**Europäisches Patentamt**

**European Patent Office**

**Office européen des brevets**

(11) Publication number : **0 346 828 B1**

# EUROPEAN PATENT SPECIFICATION

(45) Date of publication of patent specification :
26.08.92 Bulletin 92/35

(51) Int. Cl.⁵ : **G03F 1/00**

(21) Application number : **89110677.5**

(22) Date of filing : **13.06.89**

(54) X-ray absorber for use in X-ray lithography and method for fabrication thereof by sputtering.

(30) Priority : **14.06.88 JP 146546/88**

(43) Date of publication of application :
**20.12.89 Bulletin 89/51**

(45) Publication of the grant of the patent :
**26.08.92 Bulletin 92/35**

(84) Designated Contracting States :
**DE FR GB**

(56) References cited :
DE-A- 1 447 976
JP-A- 6 240 726
US-A- 3 873 824
PATENT ABSTRACTS OF JAPAN, vol. 9, no. 157 (P-369)(1880), July 2, 1985, & JP-A-60 33 556
PATENT ABSTRACTS OF JAPAN, vol. 9, no. 157, (P-369)(1880), July 2, 1985; & JP-A-60 33 555
16TH INT. CONF. SOLID STATE DEVICES AND MATERIALS, August 30 - September 1, 1984, Kobe, pages 23-26, Tolyo, JP; M. SEKIMOTOet al.: "A high contrast submicron X-ray mask with Ta absorber patterns"

(73) Proprietor : **FUJITSU LIMITED**
**1015, Kamikodanaka Nakahara-ku**
**Kawasaki-shi Kanagawa 211 (JP)**

(72) Inventor : **Yamada, Masao c/o FUJITSU LIMITED**
**Patent Department 1015 Kamikodanaka**
**Nakahara-ku**
**Kawasaki-shi Kanagawa (JP)**
Inventor : **Nakaishi, Masafumi c/o FUJITSU LIMITED**
**Patent Department 1015 Kamikodanaka**
**Nakahara-ku**
**Kawasaki-shi Kanagawa (JP)**
Inventor : **Kudou, Jinko c/o FUJITSU LIMITED**
**Patent Department 1015 Kamikodanaka**
**Nakahara-ku**
**Kawasaki-shi Kanagawa (JP)**

(74) Representative : **Greenstreet, Cyril Henry et al**
**Haseltine Lake & Co. Hazlitt House 28**
**Southampton Buildings Chancery Lane**
**London WC2A 1AT (GB)**

EP 0 346 828 B1

## Description

The present invention relates to a mask for use in X-ray lithography and a method for fabricating it, and more particularly to an X-ray absorber for use in X-ray masks of which the surface is smooth and in which distortion caused by stress set up during their fabrication is reduced.

As the design of semiconductor devices became finer, the photolithography method used for fabricating them reached its limit of resolution, which is determined by the wavelength of light. In order to achieve still finer resolution, X-ray lithography is coming to be used in place of photolithography, taking advantage of the shorter wavelength of X-rays compared with that of light. X-ray lithography is therefore becoming an important technique for fabricating next generation semiconductor devices.

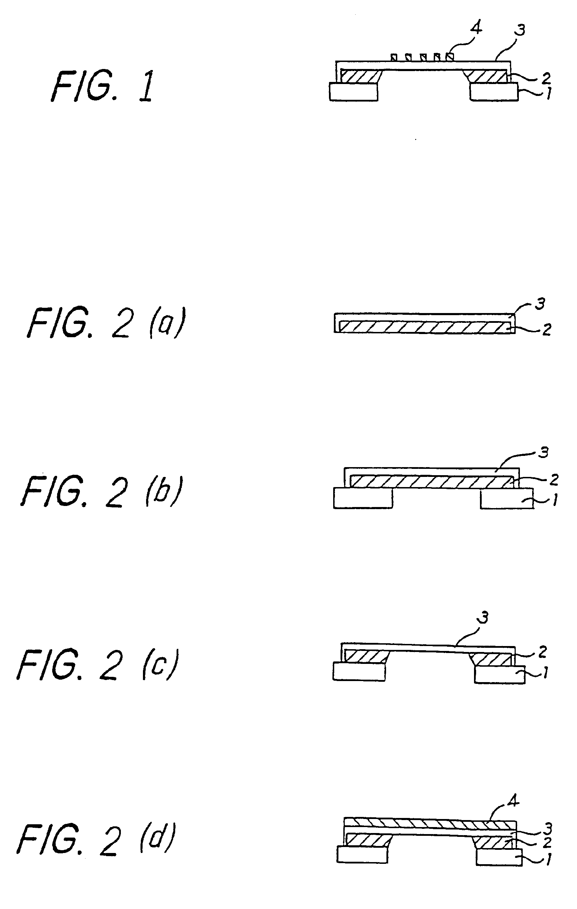

In prior art X-ray masks, heavy metals such as tungsten, gold or tantalum are used for the X-ray absorber. A schematic cross-section of an exemplary X-ray mask is shown in Fig. 1. In the Figure, the reference numeral 1 designates a frame made, for example, of ceramic, for supporting a substrate 2 made, for example, of silicon. 3 is a supporting film which is transparent to X-rays. The supporting film is made, for example, of silicon carbide (SiC). An X-ray absorbing film 4 is formed over the supporting film 3, and patterned according to the device to be fabricated.

A process for making such an X-ray mask will be described briefly with reference to Fig. 2. First, as shown in Fig. 2(a), an X-ray transparent SiC film 3 approximately 2 $\mu$m thick is deposited on a surface of a silicon (Si) substrate 2 to form the supporting film 3. The deposition is done, for example, by chemical vapour deposition (CVD). Next, as shown in Fig. 2(b), a support frame 1 about 5 mm thick is glued to the back side of the silicon substrate 2, for example with epoxy resin. The Si substrate 2 is etched off from its back side as shown in Fig. 2(c). Ordinary wet etching, for example using a mixture of hydrofluoric acid (HF), nitric acid (HNO$_3$) and acetic acid (CH$_3$COOH) can be used for this etching. Then, as shown in Fig. 2(d), a film of X-ray absorber 4 about 1 $\mu$m thick is deposited over the film 3, and patterned with a predetermined pattern. Usually, electron beam lithography is used for this fine patterning. The X-ray absorber film may be formed by CVD or sputtering. However, since it is known in the art that the density of films formed by CVD is low, their X-ray absorbing effect is poor, the X-ray absorbing film is generally formed by sputtering.

In this manner the X-ray mask is fabricated. An X-ray absorber made of tungsten (W) and titanium (Ti) is described in more detail in "Low distortion X-ray mask with W-Ti absorber" by N. Yoshioka et al, SPIE (Symposium on Photon, Ion and Electron-beam Technology, held on 2nd-4th March 1988 at Santa Clara, California, U.S.A.); volume 923, Electron-beam, X-ray and Ion-beam Technology: Submicrometer Lithographies VII (1988).

Such prior art X-ray masks, of which the X-ray absorber is made of a heavy metal or a compound thereof, have the disadvantage that their surface is not smooth, and the pattern is deformed. The deformation is caused by stresses appearing in the X-ray absorbing film during its production, and by differences in thermal expansion coefficient between the X-ray absorbing film 4 and the supporting film 3. Such stresses cannot be removed by annealing, and so the supporting film is warped and the pattern is often deformed.

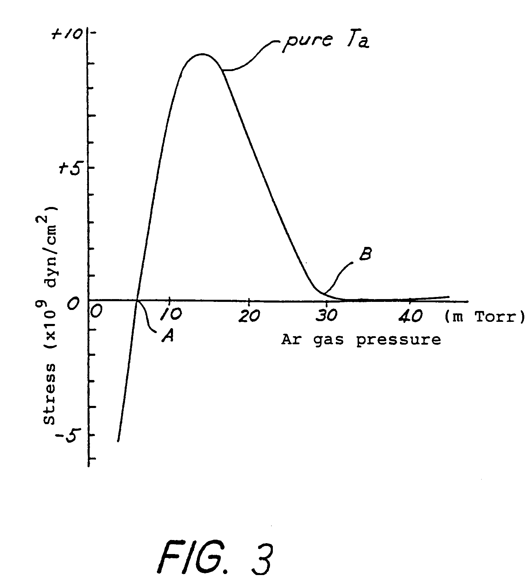

It is known in the art that the stress in a sputtered film depends on the gaseous pressure in the sputtering chamber used to form the film. Fig. 3 is a graph showing the variation of stress set up in a Ta film formed by sputtering pure Ta under various pressures of argon (Ar) gas. The ordinates indicate the stress applied to the supporting film by the Ta film formed on it, and the abscissae show the Ar gas pressure in the sputtering chamber in which the Ta film is sputtered. The plus side stress indicates a tensile stress, while the negative side stress indicates a compressive stress applied to the supporting film.

As shown in Fig. 3, there is a zero crossing point A at which the stress becomes zero. However, the curve of stress versus gas pressure is very steep at this point, and a slight deviation of the pressure from the point A therefore generates a large stress. It is difficult to maintain the pressure accurately at this point A by the state-of-the-art technology. So it is impossible to reduce the stress to a value less than $1 \times 10^8$ dyne/cm$^2$, which is an allowable value for residual stress from the point of view of distortion of the X-ray mask.

As can be seen in the curve of Fig. 3, at a pressure range higher than 30 m Torr there is a relatively flat stress region where the stress becomes very small. It seems practical to choose such a range of pressure for forming the X-ray absorber film. But the surface of the film formed at such a high gas pressure (more than 30 m Torr) becomes rough. Observation by electron microscopy revealed that the surface of the Ta film formed in a low pressure range close to the point A in Fig. 3 is very flat and smooth. But the higher the gas pressure, the rougher the surface of the sputtered film becomes. In the cross section of a Ta film formed at high pressure of more than 30 m Torr, a columnar structure of Ta crystals was observed. Small Ta crystals, approximately 1 $\mu$m long and 0.1 to 0.2 $\mu$m in diameter were grown at right angles to the surface of the supporting film and arranged in parallel to each other. The surface of the film is made rough by such Ta crystals, and contrast of the X-ray mask is reduced.

2

In practice, therefore, the sputtering is performed at a point B on the curve of Fig. 3. It is a matter of compromise between how to reduce the stress and how to maintain the surface smoothness of the mask, but usually the smoothness is still insufficient.

How to reduce the stress in the X-ray absorbing film is therefore an important problem in making an X-ray mask. Recently, the use of heavy metal nitrides as the X-ray absorber has been proposed. It is believed that the film of heavy meta formed in an atmosphere containing nitrogen becomes amorphous and reduces the stress. More detail of tungsten nitride (WN) or tantalum nitride (TaN) used for the X-ray absorber is given in Japanese Laid-open Patent No. 63-76325 by T. Kanayama et al.

A nitride film is generally formed by sputtering a target made of the nitride, or by sputtering a pure metal in a nitrogen atmosphere. The latter method is widely used because in the former method the target, made of nitride, is porous and is apt to contain contaminates. However, even in the nitride film the stress still remains.

Stability of the film is another important factor for an X-ray mask. Stress varies when the temperature is varied, because the thermal expansion coefficients of the X-ray absorbing film and its supporting film are different. Further, the stress varies when the sputtered film absorbs ambient gas, oxygen or especially humidity contained in air. Therefore, the handling of the X-ray mask must be very careful, and the conditions for using and preserving the mask are very critical.

It is a general object of the present invention, therefore, to provide an X-ray absorbing material of which sputtered film is stable and having a small stress in an X-ray absorbing film.

Another object of the present invention is to provide an X-ray mask which is stable and has a smooth surface substantially free from distortion.

A further object of the present invention is to provide a suitable sputtering method for fabricating the X-ray absorbing film.

The invention is based on the discovery that when a limited amount of one or more of aluminium (Al), titanium (Ti), silicon (Si) and molybdenum (Mo) is incorporated as additive element(s) in an X-ray absorbing film of tantalum (Ta) as the base material, the stress in the sputtered film is thereby reduced. In particular, a combination of Ta as the base metal with Al as the additive element is very good. When other heavy metals such as tungsten or gold were used as the base material, they did not show this stress-reducing effect.

Based on this discovery, the invention provides an X-ray absorbing film having the features set forth in claim 1.

The invention also provides an X-ray mask comprising the X-ray absorbing film of the invention supported on a supporting film, e.g. of silicon carbide.

A method of producing the film by sputtering is claimed in claim 7.

According to another aspect of the invention, the film may be nitrided, so that the metals are present in the film as nitrides. Such a film may be produced by sputtering the metals in an atmosphere of nitrogen and argon, as set forth more particularly in claim 9.

On varying the content of nitrogen ($N_2$) in argon (Ar) gas, and varying the pressure of the mixed gas in the sputtering chamber, the stress in the sputtered film varies in various ways. The best film is obtained with a base metal consisting of Ta and an additive element of 1% by weight Al, and sputtering them in a mixed gas composed of Ar and 10% by volume nitrogen.

One feature of the sputtering method of the present invention is in the formation of the target. The base metal and the additive element are not mixed or alloyed with each other, because it is often difficult to make a uniformly mixed or alloyed material of these metals. In this invention, therefore, a composite target is formed from the base metal and the additive element, in which an additive element such as Al is buried in the surface of the target of pure base metal. First, a target plate is fabricated from the base metal, for example Ta. A plurality of holes are then bored in the surface of the target. These holes are distributed uniformly over the surface of the target. The additive material, for example Al, is formed as studs having a diameter equal to that of the holes, and embedded in each of these holes. The diameter of the studs and their density over the area of the target are not critical.

The proportion of the additive element in the sputtered film is varied by varying the number of studs on the target. It is not always proportional to the ratio of the total area of the studs on the target to the remaining surface of the target, because the sputtering rate is different for each of the materials. The effect of changing the number and diameter of the studs is determined by quantitative analysis of the sputtered film. This seems rather troublesome, but once the number of the holes and their diameter are experimentally determined, the reproducibility is very good. This method can be applied to materials which are difficult to mix or alloy with each other.

Some embodiments of the invention will now be described by way of example with reference to the accompanying drawings, in which:

Fig. 1 is a schematic cross-section of an exemplary X-ray mask.

Figs. 2(a) through Fig. 2(d) schematically illustrate the major steps in the fabrication of an X-ray mask.

Fig. 3 is a graph showing the variation of stress in a Ta film which is formed by sputtering under various pressures of argon gas.

Fig. 4 is a graph illustrating the effect of various kinds of additive materials included in Ta films, comparing the variation of stress in the Ta films sputtered under various pressures of argon gas.

Fig. 5 schematically illustrates a sputtering equipment used for this invention.

Fig. 6 schematically illustrates the surface structure of the target used in the present invention.

Fig. 7 illustrates the effect of Al added to a Ta base metal, comparing the variation of stress with the Ar gas pressure under which various Ta films including different proportions of Al are sputtered.

Fig. 8 shows the effect of the nitrogen content of argon gas in the sputtering chamber, comparing the variation of stress in Ta films including 1% of Al sputtered under various pressures of a gas containing different proportions of argon are nitrogen.

Fig. 9 compares the nitriding effect for various additive elements included in Ta base metal sputtered under various pressures of argon gas including 10% of nitrogen.

As already explained, with heavy metals or their alloys the stress in a sputtered film of an X-ray absorber cannot be adequately reduced. In order to reduce the stress in the film the inventors tried adding different materials to the base metal of the X-ray absorber, and found that some materials having smaller atomic diameter compared to that of the base metal are effective in reducing the stress, and according to one aspect of the invention a combination of Ta as the base metal with at least one of Al, Ti, Si or Mo as the additive element was selected.

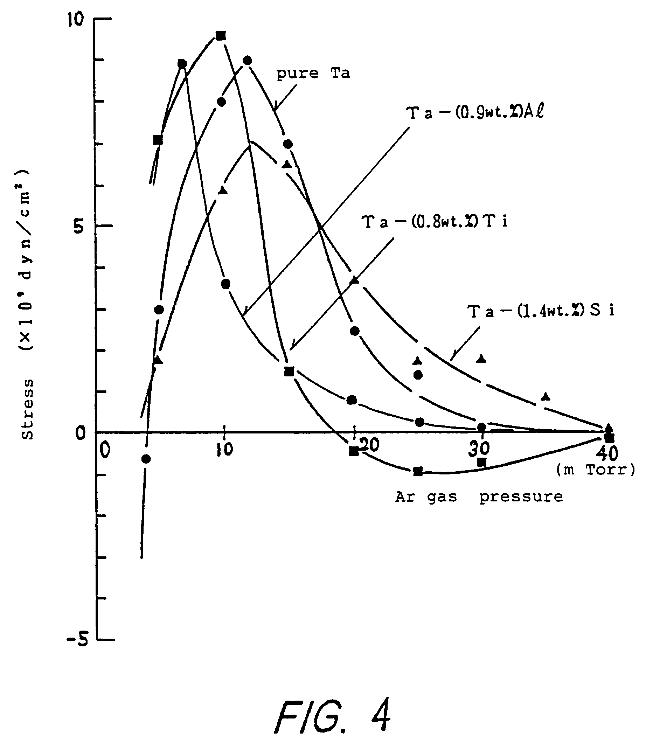

Fig. 4 shows how the stress in various films varies when the gas pressure in the sputtering chamber for forming the film is varied. In the Figure, the ordinates indicate the stress set up in the sputtered films, and the abscissae the pressure of Ar gas in the sputtering chamber when the film is sputtered. Four curves in the Figure show the variation of the stress in sputtered films respectively of pure Ta, Ta containing 0.9 weight % of Al, Ta containing 0.8 weight % of Ti, and Ta containing 1.4 weight % of Si.

The stress is measured from the curvature of a silicon substrate having the structure of Fig. 2(a), on which these films are sputtered. The SiC supporting film 3 is very thin (about 2 $\mu$m), and it never makes the Si substrate warp. But when, for example, a Ta film is sputtered on the film 3, the substrate 2 is warped. The curvature of the Si substrate 2 can therefore be considered to be due to the stress in the sputtered film.

Compared with the curve for pure Ta, the stress of Ta-Al is less than that of pure Ta, and the Ta-Al curve has a gentler slope on the right-hand flank of the curve. This means that Ta-Al can be sputtered at a lower pressure compared to pure Ta, 25 m Torr for example. A smoother surface of the film is thus obtained. The Ta-Ti curve has a zero cross-point at about 18 m Torr, and the inclination of the curve at this point is far gentler than at the zero cross-point of pure Ta. It is therefore easier to control the pressure to keep it at this point than to keep the pressure at the point A in Fig. 3. The Ta-Si curve seems to have a longer and higher flank on the right-hand side compared with pure Ta, but it has been found that the sputtered film has a smooth surface even at a pressure of 40 m Torr. As has been described above, these films of Ta containing small quantities of Al, Ti or Si as the additive element have shown better characteristics as the X-ray absorber for X-ray masks compared with pure Ta.

The effect of the additive elements Al, Ti, Si or Mo appears when these elements are added to the Ta base metal in amounts from 0.5 to 10 wt %, but the range from 1 to 3% is desirable. The density of the films is from 13.5 to 16.5, which is almost equal to that of a pure Ta film, so the masking effect for X-rays is almost the same as that of a Ta mask. At contents less than 1%, the effect of the additive elements described above is poor. Excessive additions (more than 10%) of these metals are also undesirable, because the density of the mask is decreased and the masking effect for X-rays is decreased.

For the assessment of a film as an X-ray mask, the stability of the film must be checked. The stability of a film can be expressed as the variation of stress when the film is kept under various conditions. The following table shows the maximum variation of the stress in various sputtered films when they are kept in open air ambient of 200°C for a day.

| Films | Variation of Stress (dyne/cm$^2$) |
|---|---|
| Ta-Al | $-3.6 \times 10^8$ |
| Ta-Ti | $-7.6 \times 10^8$ |
| Ta-Si | $-10 \times 10^8$ |
| Pure Ta | $-20 \times 10^8$ |
| Au | more than $10 \times 10^8$ |

The smaller the variation of the stress, the better. A minus sign for the variation indicates that the variation is in the direction of shrinking the substrate.

In the Table, pure Ta and gold are shown for the purpose of comparison. As can be seen in the Table, adding the additive elements increases the stability of the film, the combination of Ta-Al being best.

The additive elements used according to the invention also have the advantage, from the point of view of mask fabrication, that the film can be etched using ordinary semiconductor technology, and that both the base metal and the additive element can be etched in the same etching process. These requirements are not met by gold, lead of tungsten.

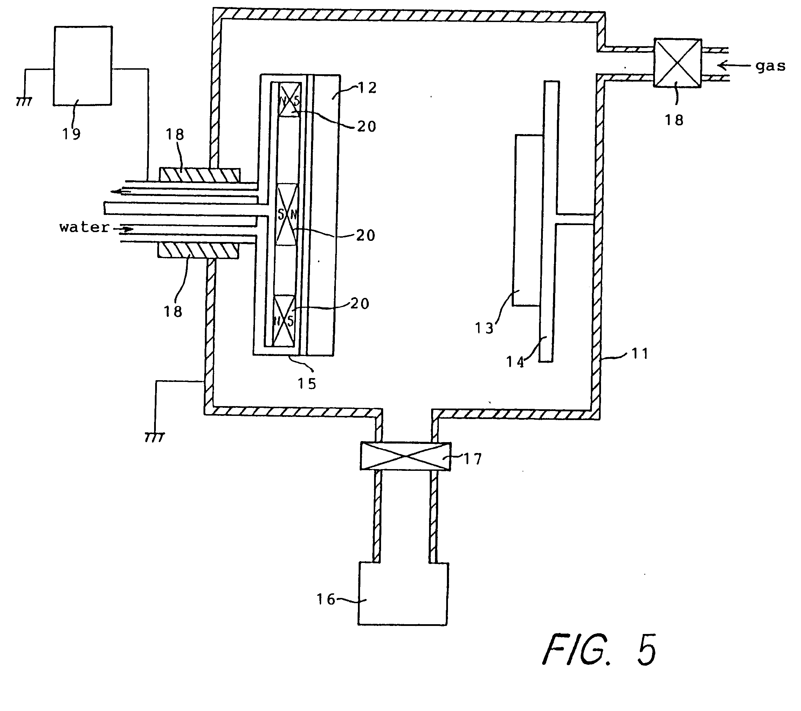

The method of sputtering the mixture of the base and additive elements will now be described. The sputtering equipment used in this invention is a conventional one used in various processes for semiconductor device manufacturing: there is no need to change this sputtering equipment. Fig. 5 schematically illustrates the main parts of a sputtering apparatus used for this invention. It is an example of a widely used magnetron sputtering apparatus. In a sputtering chamber 11, a target 12 and an object 13, on which the sputtered film is to be grown, are placed facing each other. The object 13 is the substrate as shown in Fig. 2(c), and is held by a support 14. The target 12 is a disk made of material to be sputtered, and is held by a target holder 15. The detailed structure of the target will be described later.

The sputtering chamber 11 is evacuated by a pump 16, the evacuation speed of which is controlled by a variable impedance valve 17. Inert gas, for example argon, is introduced into the sputtering chamber 11 through a control valve 18, and the gas pressure in the sputtering chamber is kept to a predetermined value. The object 13 is electrically connected to the sputtering chamber 11 and grounded, while the target holder 15 and the target 12 are electrically insulated from ground, and an electric potential is applied to them by a voltage source 19. A plasma discharge is generated in the sputtering chamber by the applied voltage, and the target 12 is bombarded by the ions generated by the plasma discharge, and sputtered on to the object 13. The target holder 15 is water cooled and provided with a plurality of permanent magnets 20 to concentrate the ions on the surface of the target and increase the sputtering efficiency. The features of the apparatus and method are all conventional and widely used, so further description is omitted for the sake of simplicity.

Usually, in order to sputter a mixture of elements, the target is fabricated from a mixture or an alloy of the element materials, or two targets made of the respective elements are used. However, it is often difficult to make a uniform mixture or alloy of these kinds of materials, and when using two targets the control of sputtering is critical, and reproducibility is not good.

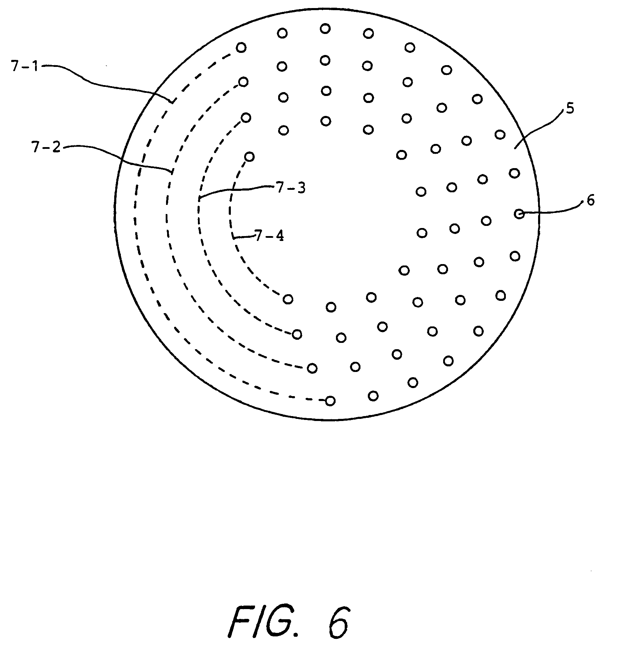

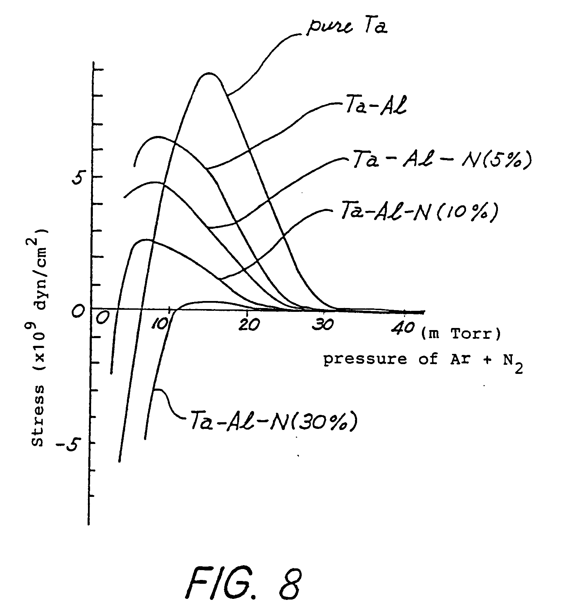

In the present invention the additive element is neither mixed nor alloyed with the base metal, but a composite target is made from these base metal and the additive element. The additive element is formed into studs and embedded into holes formed in the surface of the target, which is made of the base metal. These studs are distributed substantially uniformly over the surface of the target. Fig. 6 illustrates an example of the surface configuration of the target used for this invention. A disk 5 having a diameter of, for example, 20 cm is made of pure Ta plate, for example 6 mm thick. A plurality of holes 6 having a diameter of 5 mm and a depth of, for example, 4 mm are bored over the surface of the disk. These holes are distributed almost uniformly over the surface of the target. In the embodiment of Fig. 8, the holes 6 are arranged on four concentric circles 7-1, 7-2, 7-3 and 7-4, respectively having diameters of 18 cm, 15 cm, 12 cm and 9 cm. On each of these circles, the holes are arranged at intervals of about 1 cm between each other, and the studs are embedded into each of these holes. Inside the fourth circle 7-4 there is no hole and hence no stud is embedded, because it is empirically known that the centre portion of the target is hardly sputtered at all in the sputtering equipment used in this invention. There is therefore no point in providing the disk with the studs in its central portion inside the circle 7-4.

The distribution of the holes 6 on the target is not very critical. Therefore, many other arrangements may be possible, so long as the distribution of the holes is substantially uniform. For example, a rectangular lattice arrangement having a hole at each lattice point may be possible. Each of the holes may have a bottom or may pass through the disk. The shape and size of the target may be varied depending on the sputtering equipment.

To change the base metal, a disk made of the changed base metal is used.

The additive element, for example Al, is formed as a bar having the same diameter (for example 5 mm) as that of the holes 6, and cut into studs having a height equal to the depth of the holes. Using such a disk as the target, the sputtering of the mixed material is performed in a single sputtering process. The control of the sputtering becomes very easy and the reproducibility of the sputtered film is very good.

The content of the additive element in the sputtered film is varied by varying the number of the studs embedded in the disk. The content of the additive element does not always equal the ratio of total area occupied by the studs and remaining surface of the disk, because the sputtering rate varies between the materials, and it also depends on the sputtering equipment. In practice, for slightly varying the content, the hole distribution is not necessarily rearranged. For example, the arrangement of the holes shown in Fig. 6 is the one for forming a film of Ta including 1.2 wt % Al, which is one of the best films obtained by this invention. To decrease the content of Al, for example to 1.0 wt %, it is enough to simply pull out 20% of the studs, taking care to keep the distribution of the studs substantially uniform.

In this manner, the control of the content is very simple, and fine control can be achieved. The content of the film must be experimentally obtained from the results of quantitative analysis of the sputtered film. This seems to be troublesome, but this is a step which must be taken in any other method. Once the desirable condition has been determined in such a way, the reproducibility of the process is very good.

Gold, tungsten and lead were also tested as the base metal in this manner, but they did not show good results compared with those obtained with Ta base metal. further, these metals cannot be etched by ordinary etching processes used in the semiconductor industry.

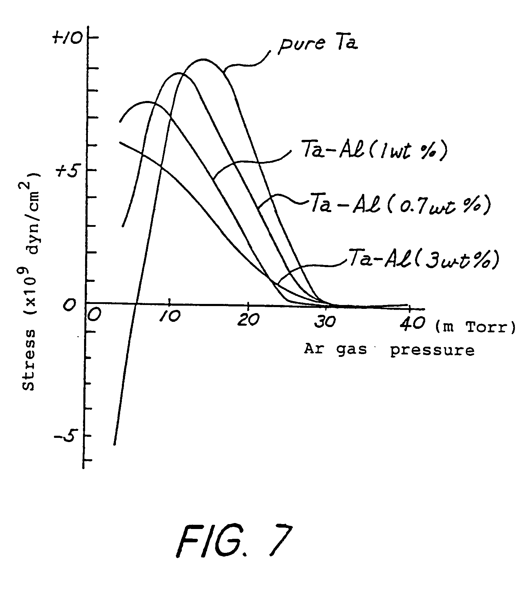

Fig. 7 shows results obtained from experiments in which the content of Al in Ta base metal was varied. The variation of stress against the sputtering pressure of Ar was measured for various sputtered films having different Al contents. The curves in Fig. 7 correspond respectively to the films including Al with the concentrations of 3, 1 and 0.7 wt %. The value of wt % is shown in brackets for each of the curves in Fig. 7. A curve for pure Ta is also added for comparison. As can be seen in the Figure, the right-hand side of the curves for the films including small amounts of Al are all lower than that of pure Ta. This means that the stress in these films is smaller than that of pure Ta, or that these films can be sputtered at a lower pressure than pure Ta, so a smoother surface is obtained. The film of Ta including 1 wt % of Al is particularly good. The stress becomes almost zero up to the pressure of 25 m Torr.

In a further embodiment of the present invention, the improved films that include Ta as base metal and an additive metal are nitrided. In order to nitride these films, mixtures of Ar gas with various proportions of nitrogen were used. The results demonstrate the effect on the stress of nitrogen added to the argon gas used for sputtering. The comparison has been done on the best film obtained in the first embodiment. Thus, Ta including 1 wt % of Al was sputtered in a mixed gas respectively comprising 5, 10 and 30 volume % of nitrogen in argon. In the Figure, the numbers in brackets show the nitrogen content in volume %. The lower three curves indicated by the reference character Ta-Al-N show the stress versus pressure characteristics for the films sputtered in an argon-nitrogen gas mixture. The upper two curves labelled pure Ta and Ta-Al shown the stresses respectively in pure Ta and in Ta including 1 wt % of Al, both sputtered in pure Ar. They are added in the Figure for the sake of comparison.

As can be seen in Fig. 8, the stress in all of the nitrided films is reduced compared to those of unnitrided films (pure Ta or Ta-Al). The slopes of the curves on the right-hand side flank became smoother, and especially in the film sputtered in argon including 30 volume % of nitrogen the stress is very small for a wide pressure range. Also the inclination of the curve at the zero intersection is very gentle. So using this material and gas composition, the stress can be reduced to almost zero. The surface is smooth because the sputtering can be done in a low pressure range. The density of the film is high (12.5 to 16.0), so a high masking effect for X-rays can be achieved. Further, it will be apparent that the control of the sputtering conditions is very easy.

This effect of nitride appears when the nitrogen gas is mixed with the argon gas in a proportion of from 5 to 40 volume %. Too high a proportion is undesirable because when too much nitrogen is added, for example more than 50%, the sputtered film becomes very rough. So, the masking effect for X-rays and the contrast of the film decreases.

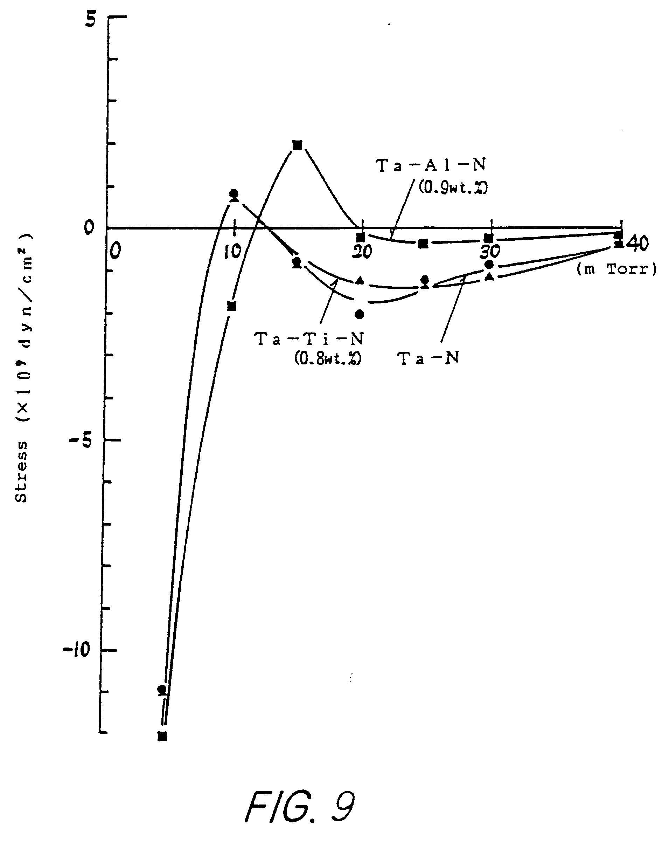

Similar tests have been made for other additive elements such as Ti, Si and Mo for Ta base metal, and have given similar effects. Fig. 9 shows the effect of nitriding applied to some of the films shown in Fig. 4. The nitriding has been done by sputtering those films in a mixture of Ar with 10 volume % of nitrogen. The comparison was made between the films: Ta including 0.9 wt % of Al, Ta including 0.8 wt % of Ti, and pure Ta. The effect of the nitriding is apparent. The peak values of the stress on the positive side are reduced. But the best effect was obtained with the combination of Ta and Al, in which the stress is very small for a wide range of pressure.

As has been described above, by adding a few percent of additive elements such as Al, Ti, Si or Mo to a base metal of Ta, the stress in the sputtered film becomes small, and the surface of the sputtered film becomes smooth and stable. If these films are sputtered in gas including nitrogen, the stress is further reduced, and sputtering can be done under lower gas pressure. This makes the control of the gas easier, and the reproducibility of the sputtered film as an X-ray absorber is increased.

The features and advantages of the present invention will be apparent from the above description, in which the present disclosed embodiments are to be considered in all respects as illustrative and not restrictive.

## Claims

1.  An X-ray absorbing film of material comprising tantalum (Ta) as base material together with one or more of aluminium (Al), titanium (Ti), silicon (Si) and molybdenum (Mo) as additive element(s) in a total amount of from 0.5 to 10% by weight of the material.

2.  An X-ray absorbing film according to claim 1, wherein the total amount of Al, Ti, Si and Mo is from 1 to 3% by weight.

3.  An X-ray absorbing film according to claim 1 or claim 2, wherein the Ta, Al, Ti, Si and Mo are present in nitrided form.

4.  An X-ray mask comprising an X-ray absorbing film according to any preceding claim supported on a supporting film.

5.  An X-ray mask according to claim 4, wherein the supporting film is made from silicon carbide.

6.  An X-ray absorbing film or mask according to any preceding claim wherein the absorbing film is a sputtered film.

7.  A method for making a film or mask according to any preceding claim, which comprises sputtering a mixture of the base material and the additive element or elements from a composite target on to a substrate in a sputtering chamber containing a gas said target being made from said base material and having a plurality of holes formed in and distributed uniformly over its surface in which studs of said additive element(s) are embedded.

8.  A method according to claim 7, wherein said gas is argon gas.

9.  A method according to claim 7, wherein said gas is a mixture of argon and nitrogen containing from 5 to 40% by volume of nitrogen.

## Patentansprüche

1.  Röntgenstrahl-Absorptionsfilm aus einem Material, welches Tantal (Ta) als Basismaterial zusammen mit einem oder mehreren von Aluminium (Al), Titan (Ti), Silizium (Si) und Molybdän (Mo) als Zusatzelement (E) in einem Gesamtbetrag von 0,5 bis 10 Gewichtsprozent des Materials umfaßt.

2.  Röntgenstrahl-Absorptionsfilm nach Anspruch 1, bei dem die Gesamtmenge von Al, Ti, Si und Mo von 1 bis 3 Gewichtsprozent beträgt.

3.  Röntgenstrahl-Absobtionsfilm nach Anspruch 1 oder 2, bei dem Ta, Al, ti, Si und Mo in Nitrid-form vorliegen.

4.  Röntgenstrahl-Maske mit einem Röntgenstrahl-Absorptionsfilm nach einem der vorhergehenden Ansprüche, der auf einem Trägerfilm getragen wird.

5.  Röntgenstrahl-Maske nach Anspruch 4, bei dem der Trägerfilm aus Siliziumcarbid hergestellt ist.

6.  Röntgenstrahl-Absorptionsfilm oder -Maske nach einem der vorhergehenden Ansprüche, bei dem der Absorptionsfilm ein gesputterter Film ist.

7. Verfahren zur Herstellung eines Films oder einer Maske nach einem der vorhergehenden Ansprüche, welches das Sputtern einer Mischung des Basismaterials und des Zusatzelementes oder der Zusatzelemente von einem Verbindungsziel auf ein Substrat in einer Sputter-Kammer umfaßt, welche ein Gas enthält, welches Ziel aus dem genannten Basismaterial besteht und eine Vielzahl von Löchern hat, die in ihm und über seiner Oberfläche gleichmäßig verteilt sind, in welcher Stifte des bzw. der genannten Zusatzelemente eingebettet sind.

8. Verfahren nach Anspruch 7, bei dem das Gas ein Argon-Gas ist.

9. Verfahren nach Anspruch 7, bei dem das Gas eine Mischung aus Argon und Stickstoff ist, welche 5 bis 40 Volumenprozent Stickstoff enthält.

## Revendications

1. Film absorbeur de rayons X réalisé en un matériau comprenant du tantale (Ta) en tant que matériau de base avec un ou plusieurs des éléments suivants, à savoir l'aluminium (Al), le titane (Ti), le silicium (Si) et le molybdène (Mo) en tant qu'élément(s) additif(s) selon une quantité totale qui va de 0,5 à 10% par unité de poids du matériau.

2. Film absorbeur de rayons X selon la revendication 1, dans lequel la quantité totale d'Al, de Ti, de Si et de Mo va de 1 à 3% par unité de poids.

3. Film absorbeur de rayons X selon la revendication 1 ou 2, dans lequel le Ta, l'Al, le Ti, le Si et le Mo sont présents sous une forme nitrurée.

4. Masque à rayons X comprenant un film absorbeur de rayons X selon l'une quelconque des revendications précédentes, ce film étant supporté sur un film de support.

5. Masque à rayons X selon la revendication 4, dans lequel le film de support est réalisé en carbure de silicium.

6. Film ou masque absorbeur de rayons X selon l'une quelconque des revendications précédentes, dans lequel le film absorbeur est un film pulvérisé.

7. Procédé de fabrication d'un film ou masque selon l'une quelconque des revendications précédentes, comprenant la pulvérisation d'un mélange constitué par le matériau de base et par l'élément additif ou les éléments additifs depuis une cible composite sur un substrat placé dans une chambre de pulvérisation qui contient un gaz, ladite cible étant réalisée à partir dudit matériau de base et comportant une pluralité de trous formés en elle et distribués uniformément sur sa surface dans lesquels des perles dudit élément additif ou desdits éléments additifs sont incorporées.

8. Procédé selon la revendication 7, dans lequel ledit gaz est du gaz argon.

9. Procédé selon la revendication 7, dans lequel ledit gaz est un mélange d'argon et d'azote qui contient de 5 à 40% d'azote par unité de volume.

FIG. 1

FIG. 2 (a)

FIG. 2 (b)

FIG. 2 (c)

FIG. 2 (d)

FIG. 3

FIG. 4

FIG. 5

EP 0 346 828 B1

FIG. 6

FIG. 7

FIG. 8

FIG. 9